# FASCICULE DE BREVET EUROPEEN

(11) **EP 1 055 149 B1**
(45) Date de publication et mention de la délivrance du brevet: **02.10.2002**
(21) Numéro de dépôt: 99913154.3
(22) Date de dépôt: 10.02.1999
(51) Int. Cl.: G02F 1/1345

(54) **CELLULE ELECTRO-OPTIQUE OU CELLULE PHOTOVOLTAIQUE ELECTROCHIMIQUE, ET PROCEDE DE FABRICATION D'UNE TELLE CELLULE**
ELEKTROOPTISCHE ZELLE ODER ELEKTROCHEMISCHE PHOTOVOLTAISCHE ZELLE UND VERFAHREN ZU IHRER HERSTELLUNG
ELECTROOPTICAL CELL OR PHOTOVOLTAIC CELL, AND METHOD FOR MAKING SAME

(30) Priorité: 11.02.1998 CH 34298; 13.02.1998 EP 98102530
(43) Date de publication de la demande: 29.11.2000
(73) Titulaire: ASULAB S.A., 2074 Marin (CH)
(72) Inventeur: RUEDIN, Yves, CH-2072 Saint-Blaise (CH); SALLIN, Michel, CH-2072 Saint-Blaise (CH); BORN, Jean-Jacques, CH-1110 Morges (CH)
(74) Mandataire: Ravenel, Thierry Gérard Louis
(86) Numéro de dépôt international: EP9900874
(87) Numéro de publication internationale: WO99041638

(56) Documents cités:
- EP-A- 0 359 082

## Description

La présente invention concerne une cellule électro-optique, en particulier à cristaux liquides, ou une cellule photovoltaïque électrochimique perfectionnée, notamment pour pièce d'horlogerie, et plus particulièrement des moyens de connexion destinés à établir une liaison électrique entre les électrodes de la cellule et un circuit électrique d'alimentation ou de commande. La présente invention concerne également un procédé de fabrication de la cellule susmentionnée.

Une première catégorie de cellules photovoltaïques connue convertit la lumière en électricité en exploitant l'effet photovoltaïque qui apparaît à la jonction de semi-conducteurs. Le matériau semi-conducteur remplit en même temps les fonctions d'absorption de la lumière et de séparation des charges électriques résultantes (électrons et trous). Le matériau devant être de grande pureté, exempt de défauts, faute de quoi électrons et trous se recombineraient avant d'avoir pu être séparés, les coûts de fabrication sont élevés.

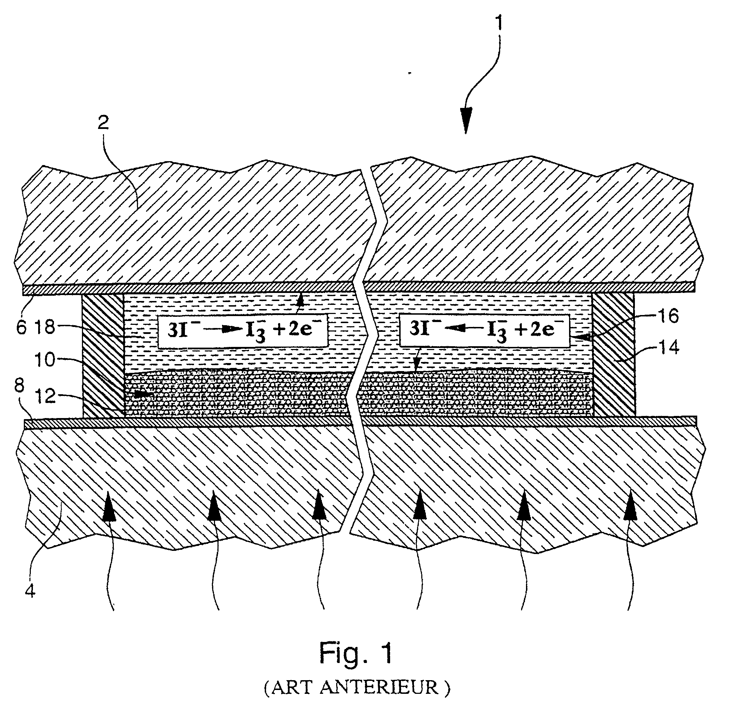

La présente invention vise un second type de cellules photovoltaïques dites électrochimiques dont une représentation schématique est donnée à la figure 1 annexée à la demande.

Une telle cellule, désignée dans son ensemble par la référence numérique générale 1, comprend une première lame avant 2 transparente et une seconde lame arrière 4 également transparente. Ces deux lames 2 et 4 comportent chacune sur leurs faces en regard une première électrode 6 encore appelée contre-électrode, et une seconde électrode 8 encore appelée photo-électrode. Ces électrodes 6, 8 sont habituellement réalisées sous la forme d'une couche mince d'un mélange d'oxyde d'indium/étain ou d'oxyde d'étain/antimoine.

La lame 4 comporte d'autre part une couche 10 réalisée sous la forme d'une structure poreuse 12 de grande surface effective constituée de particules d'un oxyde semi-conducteur actif tel que, par exemple, le dioxyde de titane TiO₂ dont le rôle sera décrit en détail ci-après.

Les lames 2 et 4 sont réunies entre elles par un cadre de scellement 14 qui s'étend le long du périmètre de celles-ci et qui définit un volume 16 rempli d'un électrolyte 18 contenant un médiateur tel que le couple redox iodure-triiodure I⁻/I³⁻.

Le dioxvde de titane TiO₂ qui constitue la couche 10 est un semi-conducteur normalement insensible à la lumière visible en raison de la largeur de sa bande interdite, et qui ne commence à absorber que dans le proche ultraviolet. Il peut néanmoins être sensibilisé par l'adsorption d'un colorant tel qu'un complexe d'un métal de transition, en particulier le ruthénium ou l'osmium, qui permet un taux de conversion photon incident/électron approchant l'unité. L'absorption de la lumière, symbolisée par des flèches sur la figure 1, est assurée par le colorant adsorbé chimiquement à la surface de la couche 10 de matériau semi-conducteur. Après avoir été excité par l'absorption d'un photon de lumière, le colorant peut transférer un électron dans la bande de conduction du semi-conducteur de la couche 10. Le champ électrique régnant au sein de la couche 10 semi-conductrice permet l'extraction de cet électron. Après transfert de l'électron, le colorant retourne à l'état fondamental oxydé. La recombinaison entre l'électron dans la bande de conduction et le trou sur le colorant oxydé est beaucoup plus lente que la réduction du colorant oxydé par le médiateur. De ce fait, la séparation de charge est efficace. Le médiateur oxydé est réduit à la contre-électrode 6.

La présente invention vise également les cellules d'affichage dites électro-optiques, en particulier à cristaux liquides qui, de manière analogue aux cellules photovoltaïques électrochimiques, comprennent :
- une première lame avant transparente dont la surface supérieure constitue la face avant de ladite cellule,
- une seconde lame arrière dont la surface inférieure constitue la face arrière de ladite cellule,
- les lames comportant chacune sur leurs faces en regard au moins une électrode, ces électrodes étant destinées à être reliées à un circuit de commande de l'affichage et venant partiellement affleurer la tranche de la lame correspondante pour y définir une zone de contact électrique en des endroits distincts du périmètre de la cellule,
- les lames étant séparées par un cadre de scellement définissant un volume pour le confinement d'un milieu optiquement actif, et
- des moyens de connexion pour établir la liaison électrique entre chaque électrode et ledit circuit de commande de l'affichage.

Un problème constant dans le domaine des cellules photovoltaïques électrochimiques du genre décrit ci-dessus réside dans les moyens de connexion à mettre en oeuvre pour établir une liaison électrique fiable entre les électrodes de la cellule et un circuit électrique d'alimentation. On rencontre également ce problème avec les cellules d'affichage électro-optiques où les électrodes de la cellule doivent être reliées à un dispositif générateur de signaux électriques de commande qui viennent modifier les caractéristiques électro-optiques de la matière confinée entre les lames de la cellule.

Le demandeur a déjà apporté une réponse à ce problème en proposant dans son brevet FR-B1-2 637 110 une cellule électro-optique perfectionnée dans laquelle chacune des deux lames de la cellule porte sur la totalité de sa surface une électrode transparente, cette électrode venant partiellement affleurer la tranche de la lame sur laquelle elle est déposée pour définir une zone latérale de contact électrique. Dans ce brevet, les moyens de connexion comprennent un plot de contact réalisé en une matière adhésive synthétique chargée de particules conductrices apportée sur la tranche de chaque lame, au droit de la zone de contact, et assurant la liaison électrique avec le circuit électrique de commande de la cellule.

A l'usage, cette technique de connexion a néanmoins présenté plusieurs inconvénients. On doit d'une part décaler les lames de la cellule l'une par rapport à l'autre, ceci afin de pouvoir accéder aux électrodes et réaliser les connexions électriques. Or, un tel agencement rend difficile la fabrication des cellules en série, notamment lorsque celles-ci sont circulaires, et nécessite des opérations supplémentaires coûteuses en temps.

D'autre part, comme rappelé ci-dessus, la liaison entre les électrodes et le circuit de commande se fait via la zone de contact électrique où chacune des électrodes de la cellule affleure la tranche de la lame sur laquelle elle est déposée. Or, l'épaisseur de cette zone de contact est très faible, typiquement de l'ordre du millier d'angströms. Il apparaît ainsi des problèmes de contact électrique, voire de rupture de la liaison mécanique entre les électrodes et les plots de contact.

D'autre part, on connaît déjà des pièces d'horlogerie telles que des montres-bracelets dans lesquelles une cellule photovoltaïque électrochimique du genre susmentionné est classiquement disposée sous la glace de façon à être suffisamment exposée au rayonnement lumineux. Par conversion de la lumière visible en un courant électrique, la cellule photovoltaïque alimente, via un circuit électrique, les moyens horométriques de la montre.

Disposée sous la glace de la montre, la cellule photovoltaïque recouvre les indicateurs horaires (aiguilles des heures, des minutes etc.) ainsi que le cadran de cette montre. Néanmoins, comme cette cellule est quasiment transparente, les indicateurs et le cadran restent visibles à travers elle.

Les connexions électriques d'une cellule électrochimique, disposées en deux endroits distincts du périmètre de la cellule, doivent toutefois être masquées afin de les rendre invisibles de l'extérieur lorsqu'on regarde à travers la glace de la montre. Pour remédier à ce problème, on ne connaît pas d'autre solution que d'augmenter la taille de la lunette pour masquer les électrodes, et donc de diminuer la surface utile de la glace et du cadran, ce qui nuit à l'esthétique de la montre ainsi qu'à la lisibilité des informations reportées sur son cadran. Une autre solution consiste à réduire les dimensions de la cellule photovoltaïque, ce qui nuit à son rendement.

Une autre solution est connue de la demande de brevet japonais non examinée No 61-201289 qui concerne une cellule à cristaux liquides comprenant une première lame avant 1a transparente, et une seconde lame arrière 1b également transparente. Ces deux lames la et 1b comportent chacune sur leurs faces en regard un jeu d'électrodes, respectivement 2a et 2b, lesdites électrodes affleurant le rebord de la lame sur laquelle elles ont été déposées pour y définir des zones de contact électrique. Des espaceurs tels que des micro-billes ou des fibres de verre sont dispersés entre les deux lames 1a, 1b afin de maintenir l'épaisseur de la couche de cristal liquide uniforme sur toute la surface de la cellule. Un connecteur est réalisé au moyen d'un film 3a isolant souple sur lequel est imprimée une encre 4 électriquement conductrice ayant des propriétés adhésives. L'encre 4 est imprimée selon des bandés sensiblement rectilignes qui présentent le même pas que les électrodes transparentes qui affleurent le long des rebords de la cellule. Entre les bandes conductrices, on imprime une encre isolante ayant des propriétés adhésives, de sorte que la surface imprimée devient plane. Le film 3a de connexion est ensuite solidarisé par pression contre les bords de la cellule pour réaliser le scellement de cette dernière. Lors de cette opération, l'encre 4 électriquement conductrice s'infiltre quelque peu entre les lames la, 1b de la cellule, de sorte que la liaison électrique s'établit entre les électrodes de la cellule et les bandes conductrices. Après application du film 3a de connexion souple contre les rebords de la cellule, le cristal liquide 5 est injecté dans l'intervalle entre les deux lames de verre 1a et 1b, soit à travers une ouverture de remplissage formée dans l'une des lames la ou 1b, soit à un endroit où le film 3a de connexion souple n'est pas encore solidarisé contre le rebord de la cellule. Après cela, l'ouverture de remplissage est scellée afin d'obtenir une cellule à cristaux liquides avec le film 3a de connexion solidarisé contre le rebord de ladite cellule.

La cellule décrite ci-dessus présente les inconvénients suivants. On doit noter, d'une part, que l'encre conductrice est directement au contact des cristaux liquides, d'où un risque non négligeable de contamination desdits cristaux et de détérioration des performances de la cellule. D'autre part, un tel procédé ne permet pas la fabrication des cellules par lots. En effet, dans le cas d'une cellule à cristaux liquides classique, le cadre de scellement permet de solidariser les deux substrats de la cellule entre eux, et de manipuler une telle cellule aisément. En particulier, l'opération de remplissage des cellules avec le cristal liquide peut s'effectuer alors que les cellules sont encore en bande, c'est-à-dire non individualisées. Au contraire, dans le cas de la demande de brevet japonais susmentionnée, les deux lames qui ne sont pas solidarisées entre elles doivent être maintenues relativement l'une par rapport à l'autre aussi longtemps que le film de connexion n'est pas solidarisé contre les rebords desdites lames. Une telle opération ne peut donc être réalisée que pièce à pièce.

La présente invention a pour objet de remédier aux problèmes et inconvénients décrits ci-dessus en proposant une cellule perfectionnée comprenant des moyens de connexion destinés à établir une liaison électrique fiable et peu encombrante entre les électrodes de la cellule et un circuit électrique d'alimentation ou de commande.

A cet effet, la présente invention a pour objet une cellule électro-optique, en particulier à cristaux liquides, ou une cellule photovoltaïque électrochimique comprenant :
- une première lame avant transparente dont la surface supérieure constitue la face avant de ladite cellule,
- une seconde lame arrière transparente ou non dont la surface inférieure constitue la face arrière de ladite cellule,
- les lames comportant chacune sur leurs faces en regard au moins une électrode, ces électrodes étant destinées à être reliées à un circuit électrique d'alimentation ou de commande et venant partiellement affleurer la tranche de la lame correspondante pour y définir une zone latérale de contact électrique en des endroits distincts du périmètre de la cellule,
- les lames étant séparées par un cadre de scellement définissant un volume pour le confinement d'un milieu photoélectriquement ou électro-optiquement actif, et
- des moyens de connexion électrique pour établir la liaison électrique entre chaque électrode et ledit circuit d'alimentation ou de commande,
caractérisée en ce que les moyens de connexion comprennent un plot de contact réalisé en une matière électriquement conductrice apportée sur chaque électrode dans la zone latérale de contact où celle-ci affleure la tranche de la lame sur laquelle elle a été déposée, de façon à combler le volume de la cavité définie par l'électrode sur laquelle le plot de contact a été déposé, la lame opposée à cette électrode, le cadre de scellement et la tranche de chaque lame, afin d'augmenter la surface de la zone latérale de contact.

Grâce aux caractéristiques de la présente invention, il est possible d'augmenter la surface de la zone latérale de contact électrique par laquelle chaque électrode de la cellule est reliée au circuit électrique d'alimentation ou de commande. La liaison électrique entre les électrodes et le circuit électrique d'alimentation ou de commande est ainsi beaucoup plus fiable.

Selon une autre caractéristique avantageuse de l'invention, les moyens de connexion électrique de la cellule photovoltaïque ou électro-optique comprennent une pièce de contact apportée au droit de la zone de contact électrique où chaque électrode affleure la tranche de la lame sur laquelle elle a été déposée, cette pièce de contact électrique réalisant le report du contact électrique sur l'une des faces avant ou arrière de la cellule.

Il est ainsi possible, par exemple, de réaliser une cellule photovoltaïque électrochimique dont les moyens de connexion électrique destinés à établir la liaison électrique entre les électrodes de la cellule et un circuit électrique d'alimentation sont renvoyés sur la face arrière de ladite cellule. Le cadre de scellement de la cellule et le report de contact sur la face arrière de celle-ci se trouvent ainsi superposés plutôt que latéralement juxtaposés comme c'est le cas dans l'art antérieur. La lunette de la pièce d'horlogerie ou tout autre moyen destiné à masquer le cadre de scellement de la cellule, masque également les zones de contact électrique de celle-ci. Les dimensions de la glace, et donc du cadran de la pièce d'horlogerie, peuvent être augmentées, ce qui favorise l'esthétique de la montre et la lisibilité des informations reportées sur son cadran. De même, la cellule photovoltaïque peut être prévue plus grande, ce qui favorise son rendement. Enfin, il n'est plus nécessaire de prévoir de décalage entre les lames de la cellule. L'encombrement de la cellule est ainsi réduit, ce qui facilite son montage notamment dans une pièce d'horlogerie. La fabrication de telles cellules peut aussi se faire par lots, permettant de réduire leur prix de revient grâce à une fabrication à grande échelle.

Selon un autre aspect, la présente invention a également pour objet un procédé de fabrication de la cellule susmentionnée dans lequel, avant individualisation des cellules, on prolonge au moyen d'un dépôt de matière électriquement conductrice chacune des électrodes de la cellule légèrement au-delà de la limite géométrique finale de ladite cellule.

Selon un aspect du procédé de l'invention, les zones latérales de contact électrique sont métallisées par évaporation sous vide ou recouvertes d'une couche d'un matériau électriquement conducteur aux endroits où seront ensuite appliquées les pièces de contact électrique.

L'invention a également pour but de fournir une pièce d'horlogerie comprenant une cellule photovoitaïque électrochimique selon l'invention destinée à alimenter, via un circuit électrique d'alimentation, notamment les moyens horométriques de la pièce d'horlogerie, et/ou une cellule d'affichage électro-optique pour la présentation d'informations.

D'autres caractéristiques et avantages de la présente invention apparaîtront plus clairement à la lecture de la description suivante d'un mode de réalisation de l'invention, donné à titre purement illustratif et non limitatif, cette description étant faite en liaison avec les dessins annexés sur lesquels :
- la figure 1, déjà citée, est une vue schématique en coupe transversale d'une cellule photovoltaïque électrochimique classique ;
- la figure 2 est une vue en coupe transversale d'une cellule photovoltaïque électrochimique selon l'invention ;
- la figure 3 est une vue en perspective de la pièce de contact électrique selon l'invention ;
- la figure 4 est une vue en perspective d'une variante de réalisation de la pièce de contact électrique selon l'invention, et
- la figure 5 est une vue de dessus d'un lot de cellules photovoltaïques électrochimiques avant individualisation.

On notera tout d'abord que, bien que la présente invention soit décrite en référence à une cellule photovoltaïque électrochimique, elle s'applique de manière identique aux cellules d'affichage électro-optiques du genre décrit ci-dessus.

D'autre part, le nombre des électrodes d'une cellule selon l'invention n'est pas limité à deux, et chacune des lames de la cellule pourra comprendre une pluralité d'électrodes déposées sélectivement selon une configuration choisie.

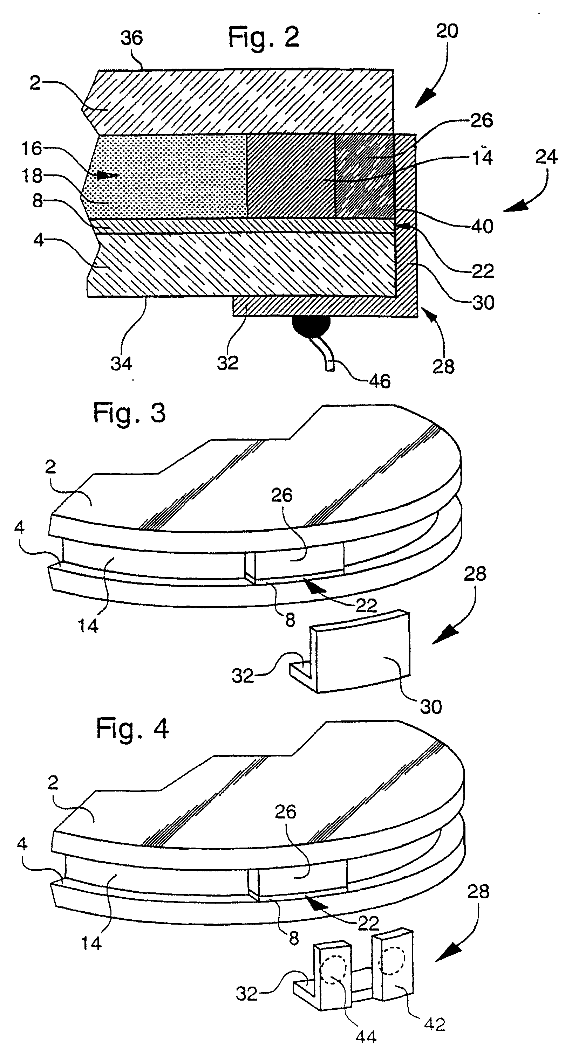

On se reporte maintenant à la figure 2 qui est une vue en coupe transversale à plus grande échelle d'une cellule photovoltaïque électrochimique selon l'invention désignée dans son ensemble par la référence numérique générale 20.

Dans tout ce qui suit, on désignera les éléments identiques à ceux décrits précédemment par les mêmes références numériques.

La cellule 20 comprend classiquement une première lame avant 2 transparente et une seconde lame arrière 4 qui peut être également transparente. Les lames 2 et 4 sont réunies entre elles par un cadre de scellement 14 qui définit un volume 16 pour le confinement d'un électrolyte 18 contenant un médiateur tel que le couple redox iodure-triiodure I⁻/I³⁻. Les lames 2 et 4 comportent chacune sur leurs faces en regard une première électrode 6 encore appelée contre-électrode, et une seconde électrode 8 encore appelée photo-électrode. La lame 4 comporte d'autre part classiquement une couche d'un matériau semi-conducteur à la surface duquel est adsorbé un colorant destiné à sensibiliser ledit semi-conducteur. Ces couches n'ont pas été représentées sur la figure 2 pour des raisons de clarté.

On décrira ci-après la connexion électrique de la photo-électrode 8 déposée sur la lame arrière 4. Il va de soi que la présente invention s'applique de façon identique à la contre-électrode 6 déposée sur la lame avant 2.

La photo-électrode 8 vient partiellement affleurer la tranche de la lame 4 pour y définir une zone latérale de contact électrique 22. Conformément à la présente invention, les moyens de connexion électrique 24 pour établir la liaison électrique entre la photo-électrode 8 et un circuit électrique d'alimentation (non représenté) comprennent un plot de contact électrique 26 apporté sur la surface de la photo-électrode 8, au droit de la zone de contact électrique 22 où la photo-électrode 8 affleure la tranche de la lame 4 sur laquelle elle a été déposée. Ce plot de contact électrique 26 peut être constitué par une matière adhésive synthétique telle que de la colle époxy chargée de particules conductrices. Le plot de contact électrique 26, en comblant le volume de la cavité définie par l'électrode 8 avec la lame avant 2 qui lui est opposée, permet d'augmenter sensiblement la surface de la zone de contact électrique 22, de sorte que la liaison électrique entre la photo-électrode 8 et le circuit électrique d'alimentation est beaucoup plus fiable et de bonne conductivité. D'autre part, il n'est plus nécessaire de prévoir de décalage entre les deux lames 2, 4 de la cellule 20, de sorte que ces lames 2, 4 peuvent être identiques, superposées l'une sur l'autre à recouvrement. On aboutit ainsi à une grande simplicité de fabrication de telles cellules, notamment dans le cas où celles-ci sont circulaires, et donc à une diminution sensible de leur prix de revient. D'autre part, l'encombrement des cellules est réduit, ce qui facilite leur montage notamment dans une pièce d'horlogerie.

Dans le cas où les lames d'une cellule selon l'invention comportent chacune une pluralité d'électrodes, on pourra prolonger le cadre de scellement de sorte qu'il forme, au droit de la zone de contact électrique où chaque électrode affleure la tranche de la lame sur laquelle elle a été déposée, des cloisons verticales de confinement afin que la colle conductrice ne puisse s'étendre latéralement et provoquer un court-circuit avec les électrodes voisines.

Selon un autre aspect de l'invention, les moyens de connexion électrique 24 sont complétés par une pièce de contact électrique 28 apportée sur la tranche de la lame 4, au droit de la zone de contact électrique 22. Cette pièce de contact électrique 28 se présente sous la forme générale d'une équerre à deux bras 30 et 32 disposés à angle droit (voir figure 3) qui réalisent le report du contact électrique sur la surface inférieure 34 de la lame 4 constituant la face arrière de la cellule 20. Ainsi, grâce à la présente invention, la connexion électrique des électrodes 6, 8 est reportée sur la face arrière de la cellule électrochimique 20 et ne se fait plus sur le côté de celle-ci, ce qui permet de réduire sensiblement l'encombrement géométrique latéral de ladite cellule 20. Il va de soi que le contact électrique pourrait être reporté de façon analogue sur la surface supérieure 36 de la lame avant 2 constituant la face avant de la cellule 20.

La pièce de contact électrique 28 est réalisée en métal ou en un alliage métallique conducteur de l'électricité dont le coefficient de dilatation sera préférentiellement adapté à celui des lames 2, 4. Elle est solidarisée sur la tranche de la lame 4 au moyen d'une couche 40 de colle époxy chargée de particules conductrices d'argent ou analogue. Selon une variante de réalisation représentée à la figure 4, le bras 30 de la pièce de contact 28 est remplacé par des languettes telles que 42 sur chacune desquelles on dépose une dose 44 de colle époxy avant montage.

La pièce de contact électrique 28 peut également être réalisée sous la forme d'une simple lame (non représentée) venant en appui sur la tranche de la lame 4, au niveau de la zone latérale de contact électrique 22.

L'extrémité d'un conducteur électrique 46 destiné à relier la photo-électrode 8 au circuit d'alimentation est fixée sur le bras 32 de la pièce de contact électrique 28.

Dans un procédé couramment utilisé pour fabriquer des lots de cellules photovoltaïques électrochimiques, on prépare deux grandes plaques de verre ou de matière synthétique, au moins l'une de ces plaques étant transparente. On réalise ensuite sur ces plaques les électrodes et les pistes conductrices, puis on dépose sur l'une des plaques une matière de scellement destinée à définir avec celles-ci un volume de confinement pour un électrolyte. Pour chaque cellule, on ménage dans la matière de scellement une ouverture de remplissage de l'électrolyte. Les plaques sont assemblées à recouvrement l'une sur l'autre pour former un ensemble comprenant plusieurs rangées de cellules ouvertes. Chaque cellule ayant une ouverture de remplissage, on remplit alors les cellules avec l'électrolyte, puis on scelle hermétiquement lesdites ouvertures de remplissage. Si le contour des cellules doit être circulaire, on peut découper les cellules au moyen d'un jet d'eau à haute pression, d'un faisceau laser ou de tout autre moyen adapté. On peut également diviser un ensemble de cellules en bandes rectilignes par des techniques de rayage et de cassure du verre suivant des droites parallèles.

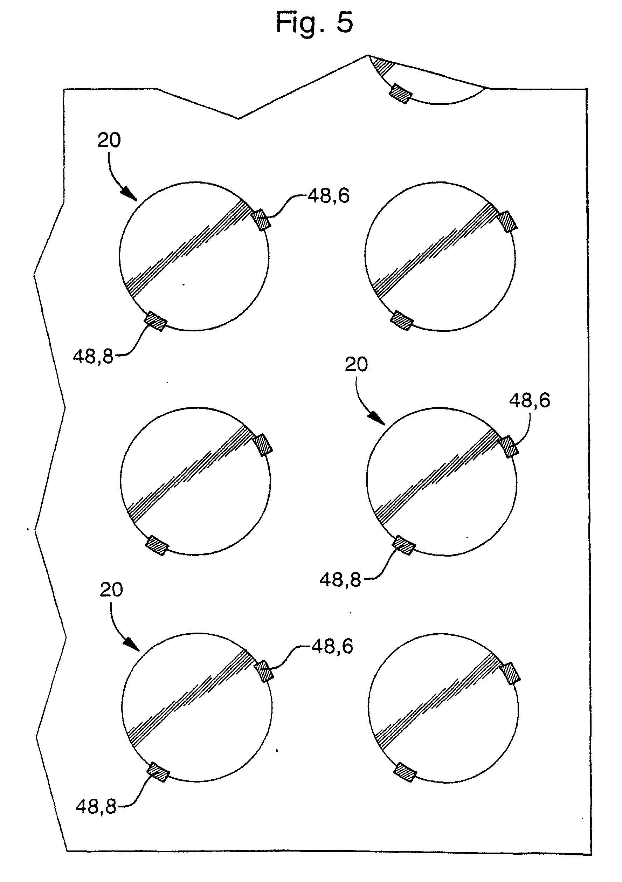

Conformément au procédé de l'invention, et comme il ressort de la figure 5, il est proposé un procédé de fabrication de cellules photovoltaïques électrochimiques 20 dans lequel, avant individualisation des cellules 20, on prolonge au moyen d'un dépôt 48 de matière électriquement conductrice telle que de la colle époxy chargée de particules conductrices chacune des électrodes 6, 8 de la cellule 20 légèrement au-delà de la limite géométrique finale de ladite cellule 20. On procède ensuite à l'individualisation des cellules 20 par les techniques susmentionnées, et on obtient ainsi des cellules 20 présentant des plots de contact électrique 26 qui affleurent la tranche des lames 2, 4 de ladite cellule 20 et permettent d'augmenter sensiblement la surface de la zone latérale de contact électrique 22 entre les électrodes 6, 8 de la cellule 20 et les moyens de connexion 24 selon l'invention.

Comme il ressort également de la figure 5, les zones latérales de contact où chacune des électrodes de la cellule affleure la tranche de la lame sur laquelle elle a été déposée ne sont pas superposées, mais décalées angulairement le long du périmètre de la cellule, afin d'éviter tout risque de court-circuit entre les électrodes.

Selon un autre aspect du procédé de fabrication de l'invention, la zone de contact électrique 22 est métallisée par évaporation sous vide ou recouverte d'une couche de matériau électriquement conducteur tel que de la colle époxy chargée de particules conductrices. La zone de contact 22 présente ainsi un excellent état de surface qui permet un contact intime avec la pièce de contact 28.

La présente invention a également pour but de fournir une pièce d'horlogerie comprenant classiquement une boîte fermée par une glace et un fond et utilisant une cellule photovoltaïque électrochimique selon l'invention comme source d'énergie, et/ou une cellule d'affichage électro-optique pour la présentation d'informations. Comme on l'aura bien compris de ce qui précède, la cellule électrochimique est capable de transformer la lumière en un courant électrique pour alimenter notamment, via un circuit électrique d'alimentation, les moyens horométriques de la pièce d'horlogerie. La cellule électrochimique selon l'invention pourra notamment être disposée entre la glace et le cadran de la pièce d'horlogerie, par exemple solidarisée sur la face arrière de la glace par collage.

Il va de soi que diverses modifications et variantes simples entrent dans le cadre de la présente invention.

## Revendications

1. Cellule électro-optique, en particulier à cristaux liquides, ou cellule photovoltaïque électrochimique perfectionnée comprenant :
- une première lame avant (2) transparente dont la surface supérieure (36) constitue la face avant de ladite cellule,
- une seconde lame arrière (4) transparente ou non dont la surface inférieure (34) constitue la face arrière de ladite cellule,
- les lames (2, 4) comportant chacune sur leurs faces en regard au moins une électrode (6,8), ces électrodes (6, 8) étant destinées à être reliées à un circuit électrique d'alimentation ou de commande et venant au moins partiellement affleurer la tranche de la lame (2, 4) sur laquelle elles ont été déposées pour y définir une zone latérale de contact électrique (22) en des endroits distincts du périmètre de la cellule,
- les lames (2, 4) étant séparées par un cadre de scellement (14) définissant un volume (16) pour le confinement d'un milieu photoélectriquement ou électro-optiquement actif, et
- des moyens de connexion électrique (24) pour établir la liaison électrique entre chaque électrode (6, 8) et ledit circuit d'alimentation ou de commande,
**caractérisée en ce que** les moyens de connexion électrique (24) comprennent un plot de contact (26) réalisé en une matière électriquement conductrice apportée sur chaque électrode (6, 8) dans la zone latérale de contact électrique (22) où celle-ci affleure la tranche de la lame (2, 4) sur laquelle elle a été déposée, de façon à combler le volume défini par l'électrode (6, 8) sur laquelle le plot de contact (26) a été déposé, la lame respectivement (4, 2) opposée à cette électrode (6, 8), le cadre de scellement (14) et la tranche de chaque lame (2, 4).

2. Cellule selon la revendication 1, **caractérisée en ce que** les lames (2, 4) sont identiques, superposées l'une sur l'autre à recouvrement.

3. Cellule selon l'une quelconque des revendications 1 ou 2, **caractérisée en ce que** le plot de contact (26) est réalisé en une matière adhésive synthétique chargée de particules conductrices.

4. Cellule selon la revendication 3, **caractérisée en ce que** la matière adhésive synthétique chargée de particules conductrices est de la colle époxy.

5. Cellule selon l'une quelconque des revendications précédentes, **caractérisée en ce que** les moyens de connexion électrique (24) comprennent en outre une pièce de contact (28) réalisée en un matériau électriquement conducteur et apportée sur la tranche de chaque lame (2, 4), au droit de la zone latérale de contact électrique (22), la pièce de contact électrique (28) réalisant le report du contact électrique sur l'une des faces avant ou arrière (34, 36) de ladite cellule (20).

6. Cellule électro-optique, en particulier à cristaux liquides, ou cellule photovoltaïque électrochimique perfectionnée comprenant :
- une première lame avant (2) transparente dont la surface supérieure (36) constitue la face avant de ladite cellule,
- une seconde lame arrière (4) transparente ou non dont la surface inférieure (34) constitue la face arrière de ladite cellule,
- les lames (2, 4) comportant chacune sur leurs faces en regard au moins une électrode (6,8), ces électrodes (6, 8) étant destinées à être reliées à un circuit électrique d'alimentation ou de commande et venant au moins partiellement affleurer la tranche de la lame (2, 4) sur laquelle elles ont été déposées pour y définir une zone latérale de contact électrique (22) en des endroits distincts du périmètre de la cellule,
- les lames (2, 4) étant séparées par un cadre de scellement (14) définissant un volume (16) pour le confinement d'un milieu photoélectriquement ou électro-optiquement actif, et
- des moyens de connexion électrique (24) pour établir la liaison électrique entre chaque électrode (6, 8) et ledit circuit d'alimentation ou de commande,
**caractérisée en ce que** les moyens de connexion électrique (24) comprennent une pièce de contact (28) réalisée en un matériau électriquement conducteur et apportée sur la tranche de chaque lame (2, 4), au droit de la zone latérale de contact électrique (22), la pièce de contact électrique (28) réalisant le report du contact électrique sur l'une des faces avant ou arrière (34, 36) de ladite cellule (20).

7. Cellule selon l'une quelconque des revendications 5 ou 6, **caractérisée en ce que** la pièce de contact (28) se présente sous la forme d'une équerre à deux bras (30) et (32) disposés à angle droit.

8. Cellule selon la revendication 7, **caractérisée en ce que** l'un des bras (30, 32) de la pièce de contact (28) est remplacé par des languettes (42).

9. Cellule selon l'une quelconque des revendications 6 à 8, **caractérisée en ce que** le coefficient de dilatation de la pièce de contact (28) est adapté à celui des lames (2, 4).

10. Procédé de fabrication d'une cellule électro-optique, en particulier à cristaux liquides, ou cellule photovoltaïque électrochimique selon l'une quelconque des revendications précédentes, **caractérisé en ce qu'**avant l'étape d'individualisation des cellules (20), on prolonge au moyen d'un dépôt (48) de matière électriquement conductrice chacune des électrodes (6, 8) de la cellule (20) légèrement au-delà de la limite géométrique finale de ladite cellule (20).

11. Procédé selon la revendication 10, **caractérisé en ce que** les zones latérales de contact électrique (22) sont métallisées par évaporation sous vide ou recouvertes d'une couche d'un matériau électriquement conducteur.

12. Pièce d'horlogerie comprenant une boîte fermée par une glace et un fond et dans laquelle est logé un mouvement horométrique, **caractérisée en ce qu'**elle utilise une cellule photovoltaïque électrochimique comme source d'énergie pour l'alimentation électrique du mouvement horométrique, et/ou une cellule d'affichage électro-optique pour la présentation d'informations, chaque cellule étant réalisée selon l'une quelconque des revendications 1 à 9.

## Claims

1. Electro-optical cell, in particular a liquid crystal cell, or an improved electrochemical photovoltaic cell including:
- a first transparent front strip (2) whose upper surface (36) constitutes the front face of said cell;
- a second back strip (4) which may or may not be transparent, and whose lower surface (34) constitutes the back face of said cell;
- the strips (2, 4) each including, on their facing faces, at least one electrode (6, 8), these electrodes (6, 8) being intended to be connected to an electric supply or control circuit and coming partially level with the edge of the strip (2, 4) onto which they have been deposited to define a lateral electric contact zone (22) in distinct locations on the cell periphery;
- the strips (2, 4) being separated by a sealing frame (14) defining a volume (16) for the confinement of a photoelectrically or electrooptically active medium; and
- electric connecting means (24) for establishing the electric connection between each electrode (6, 8) and said supply or control circuit,
**characterized in that** the connecting means (24) include a contact pad (26) made of an electrically conductive material added onto each electrode (6, 8) in the lateral electric contact zone (22) where the latter is level with the edge of the strip (2, 4) onto which it has been deposited, so as to fill the volume defined by the electrode (6, 8) onto which the contact pad (26) has been deposited, the strip respectively (4, 2) which is opposite to this electrode (6, 8), the sealing frame (14) and the edge of each strip (2, 4).

2. Cell according to claim 1, **characterized in that** the strips (2, 4) are identical, superposed and overlapping each other.

3. Cell according to either of claims 1 or 2, **characterized in that** the contact pad (26) is made of a synthetic adhesive material charged with conductive particles.

4. Cell according to claim 3, **characterized in that** the synthetic adhesive material charged with conductive particles is epoxy adhesive.

5. Cell according to any one of the preceding claims, **characterized in that** the electric connecting means (24) further include a contact part (28) made of an electrically conductive material and affixed to the edge of each strip (2, 4), to the right of the lateral electric contact zone (22), the electric contact part (28) realising the electric contact transfer on one of the front or back faces (34, 36) of said cell (20).

6. Electro-optical cell, in particular a liquid crystal cell, or an improved electrochemical cell including:
- a first transparent front strip (2) whose upper surface (36) constitutes the front face of said cell;
- a second back strip (4) which may or may not be transparent, and whose lower surface (34) constitutes the back face of said cell;
- the strips (2, 4) each including, on their facing faces, at least one electrode (6, 8), these electrodes (6, 8) being intended to be connected to an electric supply or control circuit and coming at least partially level with the edge of the strip (2, 4) onto which they have been deposited to define a lateral electric contact zone (22) in distinct locations on the cell periphery;
- the strips (2, 4) being separated by a sealing frame (14) defining a volume (16) for the confinement of a photoelectrically or electrooptically active medium; and
- electric connecting means (24) for establishing the electric connection between each electrode (6, 8) and said supply or control circuit,
**characterized in that** the connecting means (24) include a contact part (28) made of an electrically conductive material and affixed to the edge of each strip (2, 4) to the right of the lateral electric contact zone (22), the electric contact part (28) realising the electric contact transfer on one of the front or back faces (34, 36) of said cell (20).

7. Cell according to either of claims 5 or 6, **characterized in that** the contact part (28) has the shape of a square with two arms (30, 32) arranged at right angles.

8. Cell according to claim 7, **characterized in that** one of the arms (30, 32) of the contact part (28) is replaced by tongues (42).

9. Cell according to any one of claims 6 to 8, **characterized in that** the expansion coefficient of the contact part (28) is adapted to that of the strips (2, 4).

10. Manufacturing method for an electro-optical cell, in particular a liquid crystal cell, or an improved electrochemical cell according to any one of the preceding claims, **characterized in that** prior to the step of separating the cells (20), each of the electrodes (6, 8) of the cell (20) is extended slightly beyond the final geometrical limit of said cell (20) by means of a deposition (48) of electrically conductive material.

11. Method according to claim 10, **characterized in that** the lateral electric contact zones (22) are metallised by vacuum evaporation or covered with a layer of electrically conductive material.

12. Timepiece including a case sealed by a crystal and a back cover and in which a clockwork movement is housed, **characterized in that** it uses an electrochemical photovoltaic cell as a source of energy for the electric supply of the clockwork movement, and/or an electro-optical display cell for the presentation of information, each cell being made according to any one of claims 1 to 9.

## Patentansprüche

1. Perfektionierte elektrooptische Zelle, insbesondere Flüssigkristallzelle, oder perfektionierte elektrochemische, photovoltaische Zelle, die umfaßt:
- ein erstes lichtdurchlässiges vorderes Plättchen (2), dessen obere Fläche (36) die Vorderseite der Zelle bildet,
- ein zweites lichtdurchlässiges oder lichtundurchlässiges hinteres Plättchen (4), dessen untere Fläche (34) die Rückseite der Zelle bildet,
- wobei die Plättchen (2, 4) auf ihren einander gegenüberliegenden Flächen jeweils wenigstens eine Elektrode (6, 8) aufweisen, wobei diese Elektroden (6, 8) dazu bestimmt sind, mit einer elektrischen Versorgungs- oder Steuerschaltung verbunden zu werden und wenigstens teilweise mit der Schnittfläche des Plättchens (2, 4), auf die sie aufgebracht worden sind, bündig sind, um hier an verschiedenen Orten des Umfangs der Zelle eine seitliche elektrische Kontaktzone (22) zu definieren,
- wobei die Plättchen (2, 4) durch einen Einschlußrahmen (14) getrennt sind, der ein Volumen (16) für den Einschluß eines photoelektrisch oder elektrooptisch aktiven Mediums definiert, und
- elektrische Anschlußmittel (24) für die Schaffung der elektrischen Verbindung zwischen jeder Elektrode (6, 8) und der Versorgungs- oder Steuerschaltung,
**dadurch gekennzeichnet, daß** die elektrischen Anschlußmittel (24) eine Kontaktfläche (26) umfassen, die aus einem elektrisch leitenden Material hergestellt ist, das auf jede Elektrode (6, 8) in der seitlichen elektrischen Kontaktzone (22), wo diese mit der Schnittfläche des Plättchens (2, 4), auf das sie aufgebracht worden ist, bündig ist, in der Weise aufgetragen ist, daß das Volumen aufgefüllt ist, das definiert ist durch die Elektrode (6, 8), auf die die Kontaktfläche (26) aufgebracht worden ist, durch das jeweilige Plättchen (4, 2), das sich gegenüber dieser Elektrode (6, 8) befindet, durch den Einschlußrahmen (14) und durch die Schnittfläche jedes Plättchens (2, 4).

2. Zelle nach Anspruch 1, **dadurch gekennzeichnet, daß** die Plättchen (2, 4) gleich sind und mit Überdeckung überlagert sind.

3. Zelle nach einem der Ansprüche 1 oder 2, **dadurch gekennzeichnet, daß** die Kontaktfläche (26) aus einem adhäsiven Kunststoff hergestellt ist, der mit leitenden Partikeln angereichert ist.

4. Zelle nach Anspruch 3, **dadurch gekennzeichnet, daß** der mit leitenden Partikeln angereicherte adhäsive Kunststoff ein Epoxidklebstoff ist.

5. Zelle nach einem der vorhergehenden Ansprüche, **dadurch gekennzeichnet, daß** die elektrischen Anschlußmittel (24) außerdem ein Kontaktteil (28) umfassen, das aus einem elektrisch leitenden Material hergestellt ist und auf die Schnittfläche jedes Plättchens (2, 4) am Ort der seitlichen elektrischen Kontaktzone (22) aufgetragen ist, wobei das elektrische Kontaktteil (28) die Übertragung des elektrischen Kontakts auf eine der vorderen und hinteren Seiten (34, 36) der Zelle (20) bewerkstelligt.

6. Perfektionierte elektrooptische Zelle, insbesondere Flüssigkristallzelle, oder perfektionierte elektrochemische, photovoltaische Zelle, die umfaßt:
- ein erstes lichtdurchlässiges vorderes Plättchen (2), dessen obere Fläche (36) die Vorderseite der Zelle bildet,
- ein zweites lichtdurchlässiges oder lichtundurchlässiges hinteres Plättchen (4), dessen untere Fläche (34) die Rückseite der Zelle bildet,
- wobei die Plättchen (2, 4) auf ihren einander gegenüberliegenden Flächen jeweils wenigstens eine Elektrode (6, 8) aufweisen, wobei diese Elektroden (6, 8) dazu bestimmt sind, mit einer elektrischen Versorgungs- oder Steuerschaltung verbunden zu werden und wenigstens teilweise mit der Schnittfläche des Plättchens (2, 4), auf die sie aufgebracht worden sind, bündig sind, um hier an verschiedenen Stellen des Umfangs der Zelle eine seitliche elektrische Kontaktzone (22) zu definieren,
wobei die Plättchen (2, 4) durch einen Einschlußrahmen (14) getrennt sind, der ein Volumen (16) für den Einschluß eines photoelektrisch oder elektrooptisch aktiven Mediums definiert, und
- elektrische Anschlußmittel (24), die die elektrische Verbindung zwischen jeder Elektrode (6, 8) und der Versorgungs- oder Steuerschaltung schaffen,
**dadurch gekennzeichnet, daß** die elektrischen Anschlußmittel (24) ein Kontaktteil (28) umfassen, das aus einem elektrisch leitenden Material hergestellt ist und auf die Schnittfläche jedes Plättchens (2, 4) am Ort der seitlichen elektrischen Kontaktzone (22) aufgetragen ist, wobei das elektrische Kontaktteil (24) die Übertragung des elektrischen Kontakts auf eine der vorderen oder hinteren Seiten (34, 36) der Zelle (20) bewerkstelligt.

7. Zelle nach einem der Ansprüche 5 oder 6, **dadurch gekennzeichnet, daß** das Kontaktteil (28) die Form eines Winkels mit zwei rechtwinklig angeordneten Schenkeln (30) und (32) aufweist.

8. Zelle nach Anspruch 7, **dadurch gekennzeichnet, daß** einer der Schenkel (30, 32) des Kontaktteils (28) durch Zungen (42) ersetzt ist.

9. Zelle nach einem der Ansprüche 6 bis 8, **dadurch gekennzeichnet, daß** der Dehnungskoeffizient des Kontaktteils (28) an jenen der Plättchen (2, 4) angepaßt ist.

10. Verfahren für die Herstellung einer elektrooptischen Zelle, insbesondere einer Flüssigkristallzelle oder einer elektrochemischen, photovoltaischen Zelle nach einem der vorhergehenden Ansprüche, **dadurch gekennzeichnet, daß** vor dem Schritt der Trennung in einzelne Zellen (20) mittels einer Abscheidung (48) eines elektrisch leitenden Materials jede der Elektroden (6, 8) der Zelle (20) geringfügig über die geometrische Endgrenze der Zelle (20) hinaus verlängert wird.

11. Verfahren nach Anspruch 10, **dadurch gekennzeichnet, daß** die seitlichen elektrischen Kontaktzonen (22) durch Vakuumabscheidung metallisiert oder mit einer Schicht aus einem elektrisch leitenden Material bedeckt werden.

12. Zeitmeßgerät, das ein durch ein Uhrenglas und einen Boden verschlossenes Gehäuse umfaßt, in dem sich ein Zeitmeßwerk befindet, **dadurch gekennzeichnet, daß** als Energiequelle für die elektrische Versorgung des Zeitmeßwerks eine elektrochemische photovoltaische Zelle verwendet wird und/oder für die Darstellung von Informationen eine elektrooptische Anzeigezelle verwendet wird, wobei jede Zelle gemäß einem der Ansprüche 1 bis 9 beschaffen ist.
